Europäisches Patentamt

European Patent Office

Office européen des brevets

(11) Publication number: **0 090 503**
A2

# (12) EUROPEAN PATENT APPLICATION

(21) Application number: **83301080.4**

(22) Date of filing: **01.03.83**

(51) Int. Cl.³: **H 01 L 23/48, H 01 L 21/48, H 01 L 23/30, H 01 L 21/56**

(30) Priority: **25.03.82 US 361644**

(43) Date of publication of application: **05.10.83 Bulletin 83/40**

(84) Designated Contracting States: **DE FR GB IT NL**

(71) Applicant: **TEXAS INSTRUMENTS INCORPORATED, 13500 North Central Expressway, Dallas Texas 75265 (US)**

(72) Inventor: **Orcutt, John W., 3210 Collins, Garland Texas (US)**

(74) Representative: **Abbott, David John et al, Abel & Imray Northumberland House 303-306 High Holborn, London, WC1V 7LH (GB)**

(54) Apparatus and method of packaging a semiconductor device.

(57) A method of packaging a semiconductor device during which leads (312, 313) are lanced from a bar pad (3/7) of the lead frame (310). The leads (312, 313) of the lead frame (310) remain within one plane and the bar pad (317) is displaced to a different plane in order to provide the necessary separation between the ends of the leads (312, 313) and the bar pad (317) to prevent accidental connections. A region of reduced mechanical strength is provided laterally across each lead to allow the leads to be bent after the smiconductor device and the portions of the leads adjacent to the semiconductor device are encapsulated with a plastic enclosure. At least some leads have an enlarged area within the encapsulated portion of the leads to secure and anchor the leads within the plastic forming the encapsulating enclosure.

APPARATUS AND METHOD OF PACKAGING A SEMICONDUCTOR DEVICE

BACKGROUND OF THE INVENTION

Field of the Invention

This invention relates to the packaging and semiconductor devices, and, more particularly, this invention relates to the formation of lead frames for plastic encapsulation.

Description of the Prior Art

The typical semiconductor package which can be, for example, a dual in-line plastic package (hereinafter referred to as a  DIP package) has a plurality of leads which are electrically isolated from each other and entend through a plastic encapsulating enclosure to provide electrical connection to other components of an electrical circuit, for example, the individual leads on a printed circuit board.  The leads on the printed circuit board connect the DIP package to other components, for example, to the power supply and other DIP packages.  The DIP package typically has a bar pad onto which a semiconductor device, for example, an integrated circuit, is attached. The attachment of the semiconductor device to the bar pad can be, for example, by alloying or epoxying to provide an adhesion between the semiconductor device and the bar pad. The bar pad has a generally flat surface onto which one face of the semiconductor device is attached.  The other face of the semiconductor device typically includes a plurality of contact pads. Each contact pad on the semiconductor device  can be attached to a contact pad on one of the leads.  This provides the necessary electrical connections between the semiconductor device and the leads.  The leads as stated above are electrically isolated from each other and provide individual connections between the contact pads on the semiconductor device and the other  circuitry.  The bar pad is generally connected to one lead which typically is connected to ground.

In the construction of a DIP package, a lead frame is formed by photolithographic techniques or by stamping. The lead frame is metallic and the stamping process is accomplished by standard techniques in which certain areas

0090503

of a flat metal sheet are perforated. In a photolithographic technique, certain areas are coated with a material which is resistant to the effects of a corrosive. The corrosive is capable of dissolving the metal of which the lead frame is constructed. Certain areas are left uncoated and when the lead frame is exposed to the corrosive within, for example, a bath of the corrosive substance, the uncoated metal portions are eaten away and only the metal which is covered by the resistant material remains. The resistant material is then removed from the remaining metal. If the leads have been formed as attached to the bar pad, they are then separated from the bar pad by a punching operation leaving a gap between the bar pad and the lead frame. The bar pad is then displaced from the flat plane occupied by the leads to another plane. The semiconductor device is then attached to the bar pad. Each of the contact pads in the semiconductor device is connected to one of the leads adjacent to the end thereof. The attachment can be, for example, tape automated bonding, gang bonding, ball bonding, or stitch bonding. After the electrical connection is formed, the portion of the leads adjacent the bar pad, the bar pad and the semiconductor device are encapsulated by plastic to form a plastic enclosure. The portion of the leads outside the plastic enclosure are then bent in an appropriate direction. For example, if all the leads on one side of the dual in-line package are bent in a clockwise direction, the leads on the other oppsoite side of the dual in-line package are bent in a counter clockwise direction (as viewed from the same end of the package).

The leads are bent by providing an anvil into which the enclosure is nested. The edges of the anvil which are in contact with the leads extending from the enclosure are of a shape about which it is desired to form the leads. A clamp is moved into position above the anvil and is in contact with the portion of the leads which is also in contact with the anvil to clamp the leads in a secure manner. Form punches are then brought in contact with the

0090503

leads at a position which is slightly spaced from the area which is secured between the anvil and the clamp. The forms are driven in the desired direction of movement of the leads which causes the leads to deform about the edges of the anvil into the desired shape. In some instances, it is desirable to have the leads physically interconnected during the bonding operation. The physical interconnections are at a position on the lead frame which is outside the enclosure after it is formed. The physical connection between the individual leads are severed before formation of the enclosure. After separation of the physical connection between the leads is accomplished, the enclosure is formed and then placed within the anvil and clamp for the bending of the leads to the desired shape, as discussed above.

None of the prior constructions shows a lead frame from which at least one of the leads is lanced from the bar pad. Further, none of the prior constructions shows a weakened region of the lead frame being formed to allow the lead to be bent along this region of reduced mechanical strength.

Summary of the Invention

The invention has a lead frame produced for the packaging of a semiconductor device and the encapsulation thereof. A lead frame is formed with a bar pad and at least one lead connected at one end thereof to the bar pad. The lead is also attached to the outer frame of the lead frame. The outer frame provides the structural support during formation of the lead and various other steps, for example, the attachment of the semiconductor device to the bar pad. The lead which is attached at one end to the bar pad is lanced from its attachment. The lead frame is formed out of a flat metal sheet and the outer frame, the leads, and the bar pad are in a similar plane. The bar pad is then displaced from this plane into another plane to provide the necessary separation between the end of the lead which is lanced from the bar pad to prevent accidental electrical connection between the bar pad and the lead. The lead has a weakened lateral region which, after encapsulation, is located just outside the plastic enclosure. The region of reduced mechanical strength is provided to insure that the lead bends at the desired location which is the location at which the region of reduced mechanical strength is placed. The lead also includes an enlarged area, which after encapsulation and the formation of the plastic enclosure, is within the enclosure toward the end of the lead adjacent to the bar pad. This enlarged area anchors and secures the lead within the plastic enclosure to insure that the lead cannot be accidentally pulled from the plastic enlosure due to external mechanical forces.

The method of encapsulating the semiconductor device and the leads which provide the electrical connections to the external world begins with the formation of the lead frame. The lead frame is formed from a flat metallic sheet and a desired pattern of leads and supports are formed by either a standard photolithographic technique or by a standard stamping technique. After the leads and the bar pad are formed, at least one of the leads remains attached to the bar pad. This lead along with any other leads which are also attached to the bar pad are lanced away from the bar pad. The bar pad is then displaced from the plane which is occupied by the lead frame to another parallel plane. The semiconductor device is then epoxied or alloyed to the bar pad. The necessary electrical connection between the lead and an appropriate contact pad on the side of the semiconductor device away from its attachment to the bar pad is formed. The lead frame and the semiconductor device are then placed within a mold and a plastic encapsulating enclosure is formed thereabout. The portions of the leads adjacent the bar pad are encapsulated, but the narrow region of reduced mechanical strength is closely adjacent to but outside the exterior surface of the enclosure. The lead is provided with enlarged area which remains inside the encapsulated enclosure and provides the necessary securing or anchoring of the lead into the enclosure. The lead may be connected to other structures, such as other leads, during the encapsulation process. These inteconnections are outside the encapsulated area and are trimmed via a punch operation to separate the lead from all other structures. This includes the outer frame of the lead frame, if any. The lead is now completely separated except for its electrical connection to the semiconductor device and its mechanical connection to the enclosure. The end of the lead outside the enclosure is now rotated through a form operation during which a form punch contacts the lead outside of the enclosure and drives the lead in the desired direction. Since the region of reduced mechanical strength is outside the enclosure, the lead tends to deform and bend in this region. Thus, it is possible to predetermine the location of the bend without utilizing an anvil and clamp The lead can be tapered, in which case the punch contacts the lead at the wider area which also includes the region of reduced mechanical strength. The lead can be tapered toward the end of the lead outside the enclosure.

It is also possible in accordance with the present invention durng the lancing operation wherein the lead is separated from the bar pad to bend the ends of the lead in either an upward or downward direction. This bending of the lead provides the necessary physical separation between the end of the lead adjacent the bar pad and the bar pad. The remainder of the process as described above is identical except that it is not necessary that the bar pad be moved out of the plane with the remainder of the lead frame.

It is another advantage of the present invention to provide an enlarged area on a lead which allows the lead to be anchored or secured within the plastic encapsulating enclosure.

It is also an advantage of the present invention to provide a lead for a package of a semiconductor device which has a region of reduced mechanical strength outside of the plastic encapsulating enclosure which allows the leads to be bent at a predetermined area.

It is also an advantage of the present invention to provide for the severing of at least one lead from the bar pad by a lancing operation.

Another advantage of the present invention is to provide a dual in-line package which can accept a semiconductor device having a greater width in proportion to the width of the DIP package  than is possible utilizing current methods.

It is a further advantage of the present invention to provide physical separation between the ends of the leads and the bar pad by moving the bar pad to a different plane which is parallel to the plane of the leads but spaced therefrom  after the leads are separated by a lancing operating from the bar pad.

It is also an advantage of the present invention to provide a physical separation between the bar pad and the ends of the leads adjacent thereto by lancing the leads and bending the ends and the portion of the leads adjacent thereto in a desired direction out of the plane in which the remainder of the leads and the bar pad lie.

Brief Description of the Drawings

Figure 1 is a top view of a lead frame constructed according to the present invention;

Figure 2 is a side view showing a lancing operation for separating the lead of a lead frame  from a bar pad of the lead frame;

Figure 3 is a side view of a dual in-line package constructed according to the present invention prior to bending the leads in a desired direction

Figure 4 is a side view of the bending operation performed according to the present invention;  and

Figure 5 is a side view of a lancing operation in which the ends and the adjacent portion of the lead are separated  and bent away from the bar pad in a lancing operation.

Description of the Preferred Embodiment

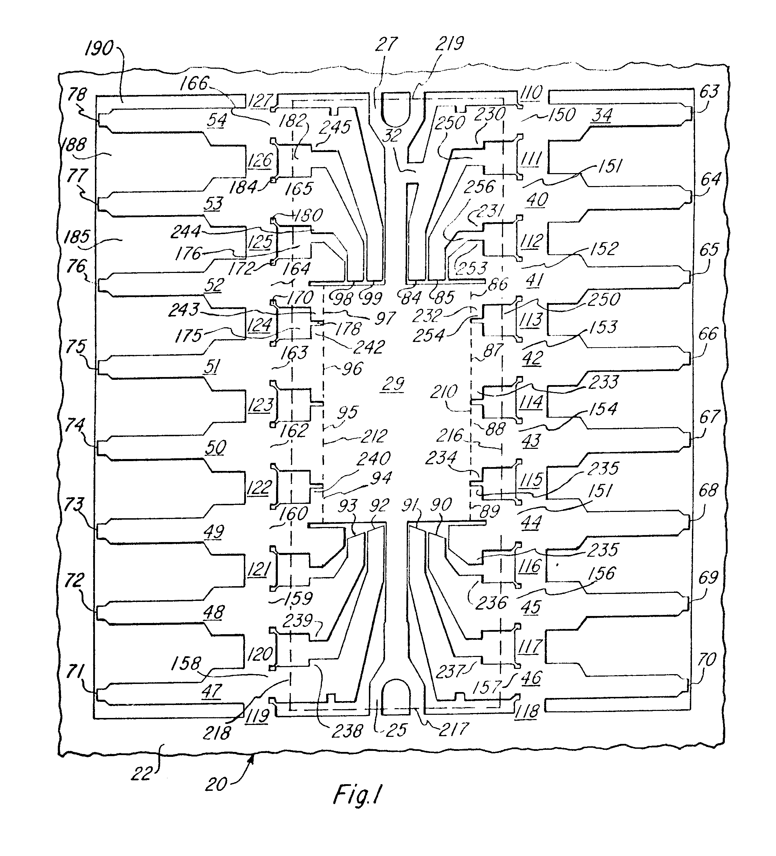

With reference to the figures, and in particular to Figure 1 thereof, a lead frame 20 is shown.  Lead frame 20 has an outer frame 22 which provides a window in which the remaining portions  of lead frame 20  are formed. The outer frame 22 can be connected at any appropriate side to other identical lead frames to form a strip of lead frames which are, for example, suitable for indexing through automated equipment. As all of the lead frames in a strip are substantially identical, a detailed discussion of lead frame 20 shall suffice for all.

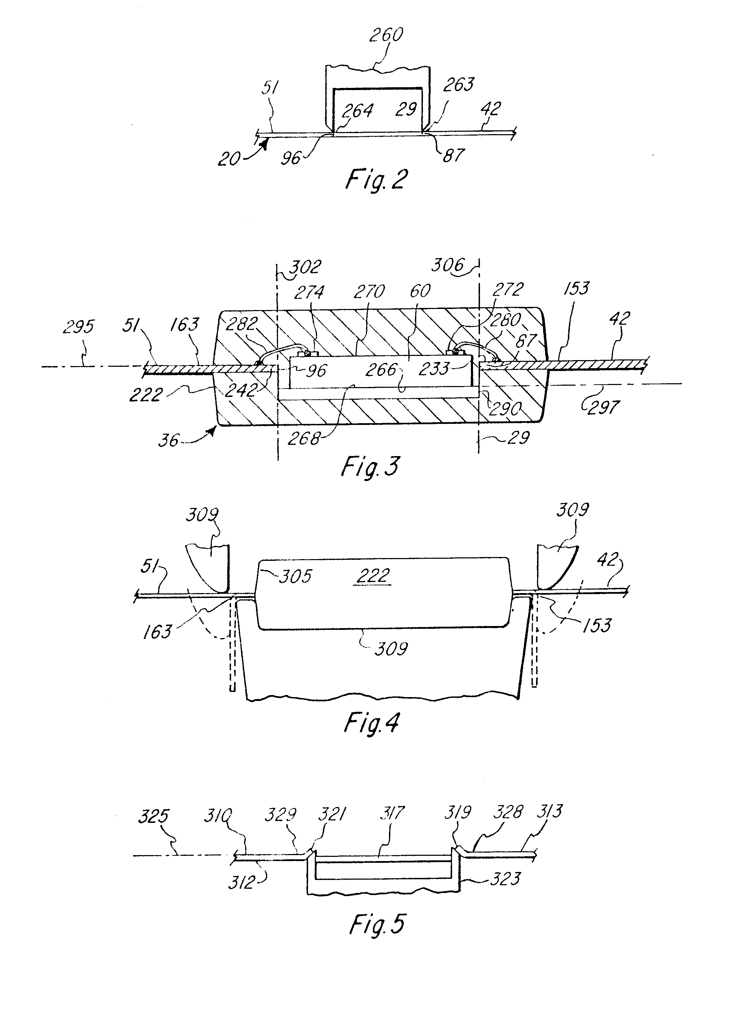

Outer frame 22 is connected through supports 25 and 27 to a bar pad 29. Support 27 is connected through spur 32 to a lead 34. Lead 34, connected to bar pad 29 through the spur 32 and support 27 to provide a means of maintaining the bar pad 29 at a desired voltage level. The lead 34 cant be connected to ground after the dual in-line package 36 (Figure 3) is connected to other circuitry (not shown). Lead frame 20 is also provided with leads 40-54. The DIP package 36 (Figure 3) is a 16 pin package which provides access through its leads to 16 different contact pads on the semiconductor device 60. Leads 41-44 and 49-52 are shown in Figure 1 as connected to the bar pad 29. Leads 34, 40, 45, 46, 47, 48, 53 and 54 are not connected to bar pad 29. These leads have been separated from the material of bar pad 29 during the stamping operation which form the leads and the various openings between the leads and the bar pads. All of the leads 34 and 40-54 are shown in Figure 1 as separated from the outer frame 22 at ends 63-78, respectively. These ends can be maintained in connection with the outer lead frame and severed at any time during the process of the formation of the encapsulated dual in-line package 36. Each of leads 34 and 40-54 extend from their ends 63-78 to an inner end 84-99, respectively, which is adjacent to or attached to bar pad 29. It is desirable in some instances to provide additional support to each of the leads 34 and 40-54 by interconnecting the leads through a series of interconnecting links 110-118. For example, link 110 connects outer frame 22 with lead 34 and link 111 connects lead 34 with lead 40. Links 110-118 interconnect leads 34 and 40-46 to form a continuous strip from one side of outer frame 22 to the other side. For example, lead 46 is connected through link 118 to outer frame 22 and

0090503

through link 117 to lead 45. In the same manner, links 119-127 interconnect leads 47-54 to the outer frame and each other. For example, lead 50 is connected through link 122 to lead 49 and through link 123 to lead 51. The lead frame 20 as shown in Figure 1 can also be formed through standard photolithographic techniques.

Each of the leads 34 and 40-54 have a region of weakened mechanical strength 150-166, respectively. The regions of weakened mechanical strength are similar and a detailed discussion of regions 165 and 164 shall suffice for all. First is must be stated that all the leads except for the interconnection provided by links 110-126 are separated from the adjacent leads and all other leads except for leads 41-44 and 49-52, which are connected to the bar pad. Region 164 extends laterally across lead 52. Region 164 is formed by producing notches 170 and 172 from openings 175 and 176, respectively. Opening 175 provides the necessary separation between leads 51 and 52 from link 124 to adjacent bar pad 29. Opening 175 has a finger 178 which extends to the edge of bar pad 29. The function of finger 78 is discussed herebelow.

Opening 176 provides the necessary separation between leads 52 and 53 between bar pad 29 and the link 125. Notches 170 and 172 extend from the respective openings 175 and 176 at an approximately 45° angle toward the center line of lead 52, a short distance into lead 52. Opening 176 also has a notch 180 which extends toward the center line of lead 53 at apprxoimately a 45° angle. Another opening 182 which separates leads 53 and 54 from their ends 98 and 99 to their connection through link 126. Opening 182 has a notch 184 which extends toward the center line of lead 53 at approximately 45° angle. The particular arrangement of openings which form the region 165 of reduced mechanical strength are by way of example only. Any standard method of forming a region of reduced mechanical strength can be utilized, for example, by providing a lateral groove in the material of lead 53 in the region 165 in order to weaken the material it is comprised of. The groove provided in the material region 165 would not be of sufficient depth to separate the material, but only sufficient to provide a generally weakened area.

Leads 52 and 53 are separated between link 125 and their ends 76 and 77 by an opening 185, and leads 53 and 54 are separated between link 126 and their respective ends 77 and 78 by an opening 188. Lead 54 is separated from outer frame 22 by an opening 190 between its connection to link 127 and its end 78. The other leads 34-52 are separated from connection with the other leads and with the outer frame 22 by opening similar to openings 186, 188, and 190. Further, the leads 34 and 40-54 are separated by openings similar to openings 175, 176 and 182. These openings provide the necessary separation between leads in order that the leads are only connected by links 110-127, except for the connections of leads 41-44 and 49-52 to bar pad 29.

During the lancing operation, the ends 86-89 of leads 41-44, respectively, are separated from bar pad 29 along the dotted line 210. Further, leads 49-52 are separated at their ends 94-97, respectively, from bar pad 29 along dotted line 212 during the lancing operation. After the encapsulation, the bar pad 29, semiconductor device 60 (Figure 3) and the portion of the leads within the rectangle formed by dotted lines 216-219 is within the enclosure formed by encapsulating that area with a plastic material. The encapsulation can be by any standard technique, for example, by transfer molding or injection molding.

It should be noted that weakened regions 150-166 are outside the encapsulating enclosure and further that the links 110-127 are outside the encapsulating enclosure. Another feature of lead frame 20 is that each of the leads 34 and 40-54 have an enlarged area 230-245. The enlarged region as defined herein is a portion of a lead which extends away from the main body of the lead into an opening adjacent thereto. The enlarged area, by extending into the opening which after capsulation is filled with the plastic material of the enclosure 222 adjacent to the

0090503

enlarged area acts as an anchor or securing mechanism which prevents the lead from being pulled from the enclosure 222 (Figure 3) by an outside mechanical force, for example, during shipment or insertion into a printed circuit board or DIP socket. The enlarged areas are somewhat similar in all the leads 34 and 40-54 and a detailed discussion of enlarged areas 230 and 232 shall suffice for all.

Enlarged area 232 comprises a small hook which extends into an opening 250 between leads 41 and 42. Thus, in this enlarged area, the lead has a somewhat greater width than it does in the area toward the dotted line 216 Figure 1) which indicates the furtherest point of encapsulation. Thus, the enlarged area represents an ability to anchor or secure the lead 34 within the enclosure 222 (Figure 1). In a similar manner, the enlarged area 232 of lead 41 has a much greater width than the width of the lead 41 along dotted line 216. Further, two hooks 253 and 254 extend into openings 256 and 250, respectively, At least the portion of the openings adjacent to the hooks 253 and 254 are filled with the plastic material of enclosure 222. The material of enclosure 222 cooperates with hooks 253 and 254 to prevent lead 41 from being pulled by external mechanical forces from the enclosure 222. For example, if it is attempted to pull lead 41 from the enclosure 222, the hooks 253 and 254 contact the material of enclosure 222 adjacent to the hooks which prevents the lead 41 from being extracted from the enclosure.

As shown in Figure 2, leads 42 and 51 are connected to bar pad 29. A lance 260 is directed toward the ends 87 and 96 of leads 42 and 51, respectively. The lance 260 is provided with two sharp cutting edges 263 and 264. The sharp edges 263 and 264 are spaced apart the distance equal to the width of bar pad 29. The sharp edges 263 and 264 contact the material of lead frame 20 at ends 87 and 86 of leads 42 and 51, respectively. In fact, the sharp edges 263 and 264 would contact the material of lead frame 20 along the entire length of dotted lines 210 and 212 (Figure 1) for severing all of the leads 41-44 and 49-52 from bar pad 29. In order to facilitate the cutting of the material of lead frame 20 along dotted lines 210 and 212 (Figure 1), the lead frame would be placed on a flat cutting surface (not shown) to allow lance 260 to have the greatest effectiveness in cutting the material cleanly along the dotted lines 210 and 212. In the process of formation of a DIP package, first the lead frame as shown in Figure 1 is formed, and then the lancing operation as shown in Figure 2 is performed. A lancing operation means a sharp cutting of the material without producing waste or scrap material. This is distinguished from a punching or stamping type operation which produces waste material.

As shown in Figure 3, after the lancing operation described in connection with Figure 2 above, the bar pad 29 is displaced by, for example, a punch, to a plane which is spaced from the plane in which the leads 34 and 40-54 are located but parallel thereto. Following the lancing of leads 41-44 and 49-52 from bar pad 29, bar pad 29 is forced out of the plane in which the leads lie. In doing so, supports 25 and 27 (Figure 1) are deformed and the substantial portion of the supports 25 and 27 can remain in the plane of the leads 34 and 40-54. Following the punching of lead 29 out of the plane of the leads 34 and 40-54, the semiconductor device 60 is attached thereto by any standard technique, for example, by an alloying or epoxying technique. For the attachment of semiconductor device 22 to bar pad 29, it is generally desirable that there be electrical contact between the surface 266 (Figure 3) of bar pad 29 and the surface 268 of semiconductor device 60. This electrical connection is in addition to the adhesive attachment of the two surfaces 266 and 268. The surface 270 of semiconductor device 60 away from its connection to bar pad 29 has a plurality of contact pads, for example, contact pads 272 and 274. An electrical connection is provided by a wire 280 between contact pad 272 and lead 42. Wire 280 can be attached betwen contact pad 272 and a position of lead 42 adjacent end 87 which is generally called a contact pad, although no specific raised area may be involved. The wire 280 can be attahed by any standard method, for example, ball bonding or stitch bonding. Further, the electrical connection can be made utilizing the techniques known as tape automated bonding or gang bonding. Wire 282 is connected between a contact pad on lead 51 adjacent the end 96 thereof and contact pad 274 on semiconductor device 60. Edges 290 and 292 of bar pad 29 are located generally adjacent but spaced from end 87 of lead 42 and end 96 of lead 82, respectively. The flat upper surface of leads 42 and 51 lie within a plane 295. The flat upper surface 266 of bar pad 29 lies within plane 297. Planes 295 and 297 are substantially parallel. End 87 and edge 290 lie generally within a plane 306 which is substantially perpendicular to planes 295 and 297. Similarly, edge 292 and end 96 lie within a plane 302 which is substantially perpendicular to planes 295 and 297. Enclosure 222, as shown in Figure 3, completely encapsulates the semiconductor device 60, and bar pad 29 and extends outward to enclose leads 42 and 51 to a point adjacent to regions 153 and 163. The regions 153 and 163 of reduced mechanical strength are located outside but closely adjacent to the exterior surface 305 of enclosure 222. The enlarged regions 233 and 242 of leads 42 and 51, respectively, are located within the enclosure 222 as are the electrical connections shown as wires 280 and 282.

As shown in Figure 4, enclosure 222 is placed against a surface 307 for support. Each lead has two flat surfaces with narrow edges. A form punch 309 is directed downward as shown in Figure 4, and contacts lead 42 along with the other leads 34 and 40-46 to rotate the leads in a clockwise movement with respect to enclosure 222 The punch contacts a flat surface of the leads. The leads are rotated to the position shown by the dotted lines in Figure 4. Region 153, because of its weaker mechanical strength, deforms, allowing precise control over the portion of lead 42 which deforms as the lead 42 is rotated clockwise from the first position (solid lines) to the second position shown by the dotted lines in Figure

0090503

4. In a like manner, leads 46-54, although only lead 51 is shown in Figure 4, are rotated from their position (as shown by the solid lines) to a position which is essentially at 90° to their prior position by rotating the leads utilizing another portion of form punch 309 which contacts the leads and forces them to rotate in a counter clockwise direction as shown in Figure 4. The two parts of punch 309 which are shown in Figure 4 would ordinarily be connected in order to provide stability. Further, enclosure 222 can be nested slightly into surface 309 as shown in Figure 4 in order to provide additional stability during the punch operation. It should be noted that the clamping of leads 34 and 40-54 is not necessary when the regions of reduced mechanical strength are employed. Note that lead 51 is bent at region 163. The regions of reduced strength allow the bending action to occur closer to the exterior surface 305 of enclosure 222 because the clamping action as shown and described in the prior art above is not necessary.

As shown in Figure 5, a lead frame 310 which is similar to lead frame 20, has leads 313 and 314 which are similar to leads 42 and 51 of lead frame 22. Lead frame 310 also has a bar pad 317 similar to bar pad 29. Lead 313 has an end 319 which was attached to bar pad 317. Further, lead 312 has an end 321 which was also connected to bar pad 317. Ends 319 and 321 are separated from bar pad 317 in a lancing operation by lance 323. Lance 323 cuts the ends 319 and 321 away from bar pad 317 and further bends the ends upward, as shown in Figure 5, out of the plane 325, which is occupied by the remainder of leads 312 and 313, and bar pad 317.

When it is desired to form electrical connections between the semiconductor device which is to be positioned on bar pad 317 and leads 312 and 313 if the connection is by ball bonding, for example, the connection to the leads would normally be made at locations indicated by reference numerals 328 and 329 on leads 313 and 312, respectively. In this type of formation of the lead frame 310, the physical separation between the ends of the leads (as

-14-

shown in Figure 5 only the ends 317 and 321 are shown) is provided by moving the ends of the leads out of the plane occupied formerly by the leads and the bar pads 317. In this structure, it is unnecessary to displace the bar pad out of plane 325 unless it is desired for other reasons. A semiconductor device similar to semiconductor device 60 (Figure 3) can be attached to bar pad 317 at the location as shown in Figure 5 without displacing it out of the plane 325. After the desired electrical connections between the semiconductor device attached to bar pad 317 and the leads of the lead frame 310 are formed, the semiconductor device, the bar pad, and a portion of the leads adjacent the bar pad are encapsulated. The leads are then bent similarly to leads 42 and 51 (Figure 4) utilizing weakened regions which were formed during the initial formation of lead frame 310.

Although a DIP package is shown herein, the invention can be utilized with any appropriate carrier, for example, a plastic chip carrier with leads extending from four sides.

Having described the invention in connection with certain specific embodiments thereof, it is to be understood that further modifications may now suggest themselves to those skilled in the art and it is intended to cover such modifications as fall within the scope of the appended claims.

WHAT IS CLAIMED IS:

1. A method of producing a lead frame comprising the steps of:

(a) forming a substantially flat, metallic frame with a centrally disposed bar pad and at least one lead attached at one end to said bar pad and extending away from said bar pad to another opposite end; and

(b) lancing said lead from said bar pad.

2. Method as set forth in Claim 1, including the step of after step b, displacing said bar pad relative to said lead with said bar pad within a first plane and said lead within a second plane substantially parallel to said first plane.

3. A package for a semiconductor device comprising:

(a) a plastic enclosure surrounding said semiconductor device and having an exterior surface;

(b) a bar pad attached to said semiconductor device and located in a first plane within said plastic enclosure and having an edge;

(c) at least one lead extending from a first end located within said enclosure in a second plane substantially parallel to said first plane through said exterior surface to a second end thereof, said edge and said one end located within a third plane substantially perpendicular to said first and second planes.

4. Package as set forth in Claim 3 wherein said lead has a narrow lateral region of reduced mechanical strength located outside said enclosure adjacent said exterior surface.

5.  Package as set forth in  Claim 4 wherein said lead is bent from said second plane along said region outside said enclosure.

6.  Package as set forth in Claim 3 including an electrical connection between said lead and said semiconductor device within said enclosure.

7.  Package as set forth in Claim 6 wherein said electrical connection includes a wire extending from a contact pad on said semiconductor device to a contact pad on said lead adjacent said one end thereof.

8.  Package as set forth in  Claim 3 wherein said lead is provided with an enlarged area of  increased width within said enclosure to secure said lead therein.

9.  A package for a semiconductor device comprising:
    (a)  a plastic enclosure surrounding said semiconductor device and having exterior surface;
    (b)  a bar pad attached to said semiconductor device and located in a first plane within said enclosure;
    (c)  at least one lead extending from one end adjacent said bar pad within said enclosure through said exterior surface to another end, said lead including a first and second portions thereof, said first portion extending within said first plane from said exterior surface to said second portion, said second portion having a length of a certain distance including said one end and extending away  from said first plane and toward said bar pad, said first portion being spaced, at the end thereof away from said exterior surface, from said bar pad said certain distance.

10.  Package as set forth in  Claim 9 wherein said first portion has an enlarged area to secure said lead within said enclosure.

11. Package as set forth in Claim 9 wherein said lead has a narrow lateral region of reduced mechanical strength located outside said enclosure closely adjacent said exterior surface.

12. Package as set forth in Claim 11 wherein said lead is bent outside said enclosure along said region from said first plane.

13. A method of packaging a semiconductor device comprising the steps of:

(a) forming a substantially flat metallic frame with a centrally disposed bar pad and at least one lead attached at one end to said bar pad and extending away from said bar pad to another opposite end;

(b) lancing said lead from said bar pad;

(c) displacing said bar pad relative to said lead to a first plane with said lead in a second plane substantially parallel to said first plane;

(d) attaching said semiconductor device to said bar pad;

(e) forming an electrical connection between a contact pad on said semiconductor device and said lead; and

(f) encapsulating said semiconductor device, said bar pad, and a portion of said lead adjacent said bar pad, including said electrical connection.

14. Method as set forth in Claim 13 wherein steps (b) and (c) are performed simultaneously.

15. The method of packaging a semiconductor device comprising the steps of:

(a) forming a lead frame with a bar pad and at least one lead attached at one end to the bar pad and extending to another opposite end within a first plane;

(b) lancing said one end from said bar pad, and bending said one end and a portion of said lead adjacent thereto away from said first plane;

    (c)   attaching said semiconductor device to said bar pad;

    (d)   producing an electrical connection between a contact pad on said semiconductor device and said lead adjacent said one end thereof; and

    (e)   encapsulating said semiconductor device, said bar pad, and a portion of said lead adjacent said one end including said electrical connection.

16. Method as set forth in Claim 15 wherein steps (b) and (c) are formed simultaneously.

17. A method of packaging a semiconductor device comprising the steps of:

    (a)   forming a substantially flat lead frame including a bar pad and at least one lead attached to said bar pad at one end and extending to another opposite end thereof with a lateral region of reduced mechanical strength intermediate said one end and said another end and an area of increased width intermediate said region and said one end;

    (b)   lancing said lead at said one end thereof from said bar pad;

    (c)   displacing said bar pad relative to said lead to a first plane with said lead in a second parallel plane;

    (d)   attaching said semiconductor device to said bar pad;

    (e)   forming an electrical connection between a contact pad on said semiconductor device and said lead adjacent said one end;

    (f)   encapsulating said semiconductor device, said bar pad, and a portion of said lead extending from adjacent said region to said one end; and

    (g)   bending said lead along said region away from said second plane.

Fig.1

Fig. 2

Fig. 3

Fig. 4

Fig. 5